# EUROPEAN PATENT SPECIFICATION

(11) **EP 2 036 317 B1**
(45) Date of publication and mention of the grant of the patent: **01.12.2010**
(21) Application number: 07733062.9
(22) Date of filing: 04.06.2007
(51) Int. Cl.: H04M 3/22

(54) **OFFICE ID REMOTE WITH OSCILLATING CIRCUIT**
OFFICE-ID-FERNEINHEIT MIT SCHWINGKREIS
UNITÉ DISTANTE "OFFICE ID" AVEC CIRCUIT OSCILLATEUR

(30) Priority: 09.06.2006 GB 0611413
(43) Date of publication of application: 18.03.2009
(73) Proprietor: Tempo Europe Limited, London WC1R 4EB (GB)
(72) Inventor: DRISCOLL, Paul, Denis, Newport NP19 8LR (GB); NURTON, Carl, Linsey, Nelson CF46 6HL (GB); GOVIER, Mark, Samuel, Cardiff CF3 4AS (GB)
(74) Representative: Kenrick, Mark Lloyd
(86) International application number: PCT/GB2007/002046
(87) International publication number: WO 2007/141500

(56) References cited:
- JP-A- 5 322 958
- JP-A- 7 211 158
- US-A- 4 054 759
- US-A- 4 901 004
- US-A- 4 916 444
- US-A- 5 541 586

## Description

### BACKGROUND OF THE INVENTION

Wiremapping devices are used in the Voice, Data, and Video industry to diagnose the termination and integrity of cables between different locations. These devices usually include a main test unit and at least one remote unit, which are connected at different ends of a single cable using RJ11/12 jacks for telephone cables, RJ45 jacks for communication cables, and F connectors for coaxial cables. Once this physical connection has been made, these devices begin a series of test protocols to detect a number of problems associated with the particular type of cable that is being tested, whether it is a coaxial, telephone, or communications cable.

Coaxial cables are typically tested for opens and shorts. If there are open or short circuits, then time domain reflectometry technology (TDR) is frequently used to determine the distance from the main test unit to the fault so that a repair can be made. When a four twisted pair communications cable is being tested, the device usually detects opens, shorts, miswires, reversals, and split pairs as part of the wiremapping process. TDR technology is also used to indicate the location of any faults. In addition, an AC signal is sent down each twisted pair to determine if there are any split pairs. If the pair is properly terminated, then the phase differential of the signal as it passes through each wire of the pair cancels the signal out. If the pair is split, then the signal is not canceled out and can be detected.

In situations where more than one cable is terminated at a patch panel and it is unclear what the source of each of the cables is, additional remote units are provided for connection at the remote ends of the various cables to indicate to the main test unit which cable at the patch panel corresponds to which office cable. This function is often referred to as office ID function. Accomplishing the office ID function is the most complicated in a communications cable (such as a four twisted pair communications cable) application because this application requires a large number of identification tags as compared to the other two applications (i.e., open / shorts or split pairs). For example, a four twisted pair communications cable requires three different identification tags for three of the twisted pairs and another identification tag for the office ID for a remaining one of the twisted pairs. This may require 11 different electrical identification tags, e.g., the three different identification tags and eight different potential electrical identification tags utilized for the Office ID function. If polarity for each pair is also tested, then double the number of electrical identifications tags may be necessary. Finding an economical and accurate method for establishing this many identification tags can be a problem.

One method for office identification includes providing a main unit with a microcontroller and a plurality of remote units that also have microcontrollers. The remote units send bits of information via their microcontrollers to the main unit to perform the office ID function. The advantage of this technique is that it can handle a vast number of remote identifications with great accuracy. The disadvantage is that this is relatively expensive and may require a higher current requirement in the remote circuitry than is preferable

United States Patent No. 4,916,444 describes a method and apparatus for establishing and maintaining a map of communication lines connected between remote locations, and a central location.

United States Patent No. 4,054,759 describes a circuit for central measurement of transmission quality of subscriber loops to verify the serviceability of the loops without involving participation by persons remote from the central location.

Another technique that is used for the Office ID function is to provide a main unit with a microcontroller and a DC power supply and a plurality of remotes, which use networks that have resistors and capacitors of different values in conjunction with a diode. Each RC combination creates a different time constant, which creates an identification tag for that particular twisted pair. In operation, the DC power supply sends current to one of these resistor, capacitor, and diode combinations in the remote unit, and providing that the polarity of the twisted pair is correct, the capacitor begins to charge. The time that is necessary for the capacitor to charge is measured by the microcontroller of the main unit and compared to a stored table to see with which time constant that pair matches up. Of course, another RC/diode combination is required to perform the office ID function as well. This may take a large number of different resistor, capacitor, and diode combinations to provide the necessary number of identification tags. For example, 11 remote units may be necessary when utilizing the RC/diode combinations.

This method has two disadvantages. First, it is difficult to obtain enough resistors and capacitors of different values to obtain this many identification tags, e.g., over 11 or 22 identification tags depending on the embodiment. Also, it is difficult to have a large number of significantly different resistors and capacitors, because the resistors and capacitors have standard values with tolerances. Due to the tolerances inherent in the standard resistors and capacitors, it is difficult to have predictable and stable values for the RC constants. Second, measuring time constants can be slow and less accurate than desirable, creating the possibility of improper matching of time constants to those stored in the data table of the main test unit. This, of course, can lead to incorrect diagnoses and hinder any troubleshooting that is necessary.

Accordingly, there exists a need for a method and apparatus for creating an identification tag for wire that is less complex, less costly, and more reliable than is currently available. This will make it easier to provide a remote unit that can perform both the wiremapping and office ID functions in an economical manner.

### SUMMARY OF THE INVENTION

The present invention includes a method for identifying a cable that has at least two conductors comprising the following steps. First, a current signal or a voltage signal is supplied to one of the conductors. The current signal or voltage signal is transformed into an oscillating waveform that has a predetermined characteristic. The value of the characteristic of the waveform is measured. The value of the characteristic of the waveform is compared to values stored in a table, which correlates a cable identity with the value of the characteristic of the waveform. The identity of the cable is then communicated to a user. Illustratively, the transforming of the current may include creating a waveform with a predetermined rate of repetition, while the step of measuring the waveform may include determining that rate of repetition.

In the present invention, a system for performing the invention includes a main test unit, a remote unit, and a cable. A main test unit includes a power supply, a memory, a comparison circuit, and a measurement circuit or measurement logic. A remote unit includes an oscillator circuit or oscillator logic. The cable utilized in the system includes at least two conductors that connect or couple the remote unit to the main test unit so that a current signal or a voltage signal can be conveyed to the remote unit from the main test unit through one of the conductors. The oscillator circuit in the remote unit receives the current signal (or the voltage signal) and creates an oscillating waveform having a predetermined characteristic utilizing the received current signal or voltage signal. The oscillating waveform is then conveyed back to the main test unit through another conductor of the at least two conductors and the main test unit measures the value of the predetermined characteristic. The main unit compares the measured value of the characteristic to those stored in the table in the memory of the main test unit to ascertain from which remote unit the oscillating signal was sent. Illustratively, this characteristic may be the rate of repetition of the waveform or some other identifying trait. Once the match has been made between the cable and the measured characteristic of the oscillating waveform, the cable's identity is communicated to the user.

In another embodiment, the main unit may include a current source that supplies current to a cable. The remote unit may include an oscillator circuit that creates an oscillating waveform of a particular profile on the cable. The main unit includes measurement circuit (or measurement logic) that can measure a particular trait of the waveform and memory housing stored values, wherein the main unit compares the measured particular trait to stored trait values in the memory, where the trait values also include a cable identification. The result of the comparison is a match between the trait values stored in memory and the measured trait, which then provides the cable identification.

### BRIEF DESCRIPTION OF THE DRAWINGS

FIGURE 1(a) illustrates a block diagram of a remote identification (ID) system according to an embodiment of the present invention;
FIGURE 1(b) is a schematic of the main test unit and remote unit of an embodiment of the invention;
FIGURE 2 is a schematic of the remote unit of an embodiment of the invention;
FIGURE 3 is a table showing values of resistors utilized in the schematic of FIGURE 2 that create the appropriate rates of repetition for eight office ID remote units according to an embodiment of the invention; and
FIGURE 4 is a flowchart illustrating a method of remote cable identification according to an embodiment of the invention.

### DETAILED DESCRIPTION OF THE INVENTION

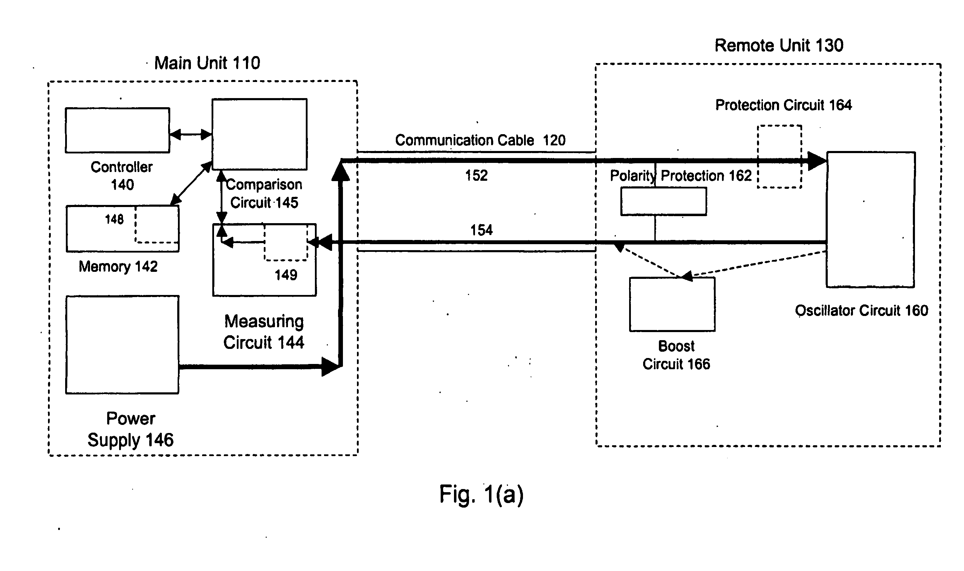

Figure 1(a) illustrates a block diagram of a cable remote identification system according to an embodiment of the invention. The cable remote identification system 100 includes a main unit 110, a cable 120, and a remote unit 130. In an embodiment of the invention, the main unit 110 may include a controller 140, memory 142, measurement circuitry 144, a comparison circuit 145, and a DC power source 146. In an embodiment of the invention, the measurement circuitry 144 and the comparison circuit 145 may be a measurement module 144 or a comparison module 145, respectively, because the function of the circuitry may be implemented in software.

In an embodiment of the invention, a microcontroller 140 may execute instructions to operate the main test unit. In an embodiment of the invention, the microcontroller 140 may execute instructions to cause the comparison module 145 in order to compare the measured value to values in a table. In an embodiment of the invention, the microcontroller 140 may include the memory 142 and the measurement circuitry 144. In an embodiment of the invention, the microcontroller 140 may include the memory, the measurement circuitry 144, and the comparison circuit 145. In an alternative embodiment of the invention, the microcontroller 140, the memory 142, and the measurement circuit 144, and the comparison circuit 145 may be separate devices and may be coupled or connected together. In an embodiment of the invention, the memory 142 may include a table 148. The table 148 may include values representing characteristics of a waveform and a cable identification associated with the waveform characteristics. In an embodiment of the invention, the measurement circuitry 144 may include a comparator 149. The comparator 149 may be utilized to increase the resolution of the oscillating waveform. In an embodiment of the invention, the comparator 149 may be a voltage level comparator that is used to detect incoming pulses from the remote unit 130. The comparison circuit 145 may receive the signal from the measurement circuit 144, wherein the measurement circuit determines the operating characteristic of the received signal from the remote unit 130. In an embodiment of the invention, the microcontroller 140 may execute instructions to cause the comparison circuit 145 to compare the operating characteristic of the received signal with the table of waveform characteristics stored in the memory 142. If a match is made between the operating characteristic of the received signal and one of the waveform characteristics in memory 142, the microcontroller 140 may generate a signal or message identifying which of the cables identifications (e.g., cable electrical identifications) has a corresponding operating characteristic to the received operating characteristic.

In an embodiment of the invention, the cable 120 may include a plurality of conductors. In Fig. 1(a), two conductors 152 and 154 are illustrated, although a cable may have a plurality of conductors. In an embodiment of the invention, a signal transmitted from the main unit to the remote unit 130 utilizes a first conductor 152. The signal transmitted from the remote unit 130 to the main unit 120 may utilize a second conductor 154. Alternatively, the signal may be transmitted from the remote unit 130 to main unit 110 on the first conductor 152. In an embodiment of the invention, the cable 120 may include a number of twisted pairs, each of which have at least two conductors.

In an embodiment of the invention, the remote unit 130 includes a oscillator circuit 160. In an embodiment of invention, the remote unit 130 may include a polarity protection circuit 162. In an embodiment of the invention, the polarity protection circuit 162 may be placed in parallel with the conductors with the cable 120, e.g., conductors 152 and 154, in order to protect the oscillator circuit 160 if a polarity of the current signal or the voltage signal is switched. In an embodiment of the invention, the remote unit 130 may include a current or voltage protection circuit 164 to protect the oscillator circuit 160 from damage if a higher than expected value of a voltage is received from the main unit. The current or voltage protection circuit 164 may limit a value of the current signal or the voltage signal which is supplied to the oscillator circuit 160 in the remote unit 130 in order to.protect the oscillator circuit 160. In an embodiment of the invention, the remote unit 130 may include a boost circuit 166. The boost circuit 166 may receive the oscillating waveform from the oscillator circuit 160, boost an amplitude of the oscillation waveform or signal to generate an amplified oscillation waveform, and transmit the oscillation waveform via a conductor on the cable 120 to the main unit 110.

In an embodiment of the invention, the remote unit may include a plurality of RC constant circuits along with the oscillator circuit 160. In this embodiment of the invention, the remote unit 130 may be utilized for identifying four cable pairs in a four twisted-pair communication cable. Three cable pairs may be identified by three RC constant circuits and one cable pair may be identified by the oscillator circuit 160. In this embodiment of the invention, the remote unit 130 could also include the current or voltage protection circuit 164, the boost circuit 166, or the polarity protection circuit 162.

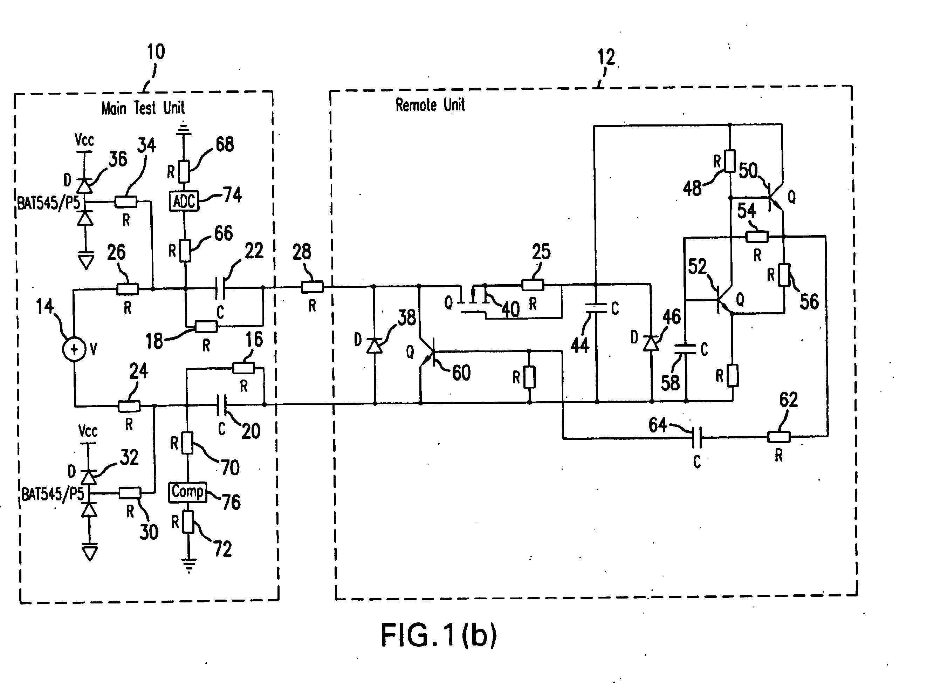

Figure 1(b) shows the wiring schematic of the main test unit 10 and remote unit 12 according to an embodiment of the present invention. The driver circuit in the main test unit 10 includes a five-volt power source 14 that simulates the output of a pair of tristate buffers that are used during various testing protocols of the apparatus. During most of the wiremapping process, this power source 14 supplies DC current with resistor 16 and resistor 18 providing the paths to get this current to the line or conductor being tested. When a fault location is being determined using TDR technology, capacitors 20, 22 provide a bypass for the high frequency pulses while resistors 24, 26 make sure that the total impedance for the driver circuit is a specific value, e.g., one hundred ohms. Once any current, whether DC or AC, exits the main test unit 10, the current passes through the cable being tested whose resistance is represented by resistor 28 and is usually negligible for short runs. It should also be noted that resistor 30 and diode 32 branch off on one side of the power source 14 while resistor 34 and diode 36 branch off on the other side of the power source 14. These components provide protection for the circuitry of the main test unit 10 if any voltages that exceed the power supply rails or thresholds of the driver circuit are applied to the main test unit 10. In an embodiment of the invention, these components, e.g., resistor 30, diode 32, resistor 34, and diode 36 may be referred to as a main unit voltage protection circuit.

When the main test unit 10 is in the office ID mode, the power source 14 may supply five volts of DC power of either polarity which results in a current being supplied and transmitted from the main test unit 10 to the cable. After the current has passed through the cable being tested, it enters the remote unit 12 and encounters a diode 38 that is connected in parallel to the incoming and outgoing conductors of the cable being tested. If the voltage applied to the remote unit 12 is reversed, then the diode 38 short circuits the incoming current and prevents damage to the rest of the circuitry found in the remote unit 12. In an embodiment of the invention, this protection circuit may be referred to as a polarity protection circuit 162. It is preferred to use a diode in parallel rather than in series because the diode 38 would create too great a voltage drop if the diode were placed in series with the incoming current. Diode 38 also provides the additional function of indicating whether a DC current is present during the wiremapping process.

Assuming that the polarity of the power source 14 is correct during the office ID function, the incoming current from the main unit 10 encounters a protection circuit, e.g., a depletion mode MOSFET 40 and a resistor 25, that limit the amount of current that is supplied to the remote unit 12 to a specified current, e.g., one milliamp. The MOSFET 40 and the resistor 25 may be referred to as a current protection circuit 164. The current protection circuit 164 ensures that the circuitry of the remote unit 12 will not be damaged if a voltage that is greater than intended is applied to it. For example, the voltages for which the circuits in the remote unit 12 is protected may be, for example, 48 V DC up to 120 V AC. In an embodiment of the invention, the circuits may operated reliably with voltages of between 2.0 and 15 Volts.

The current is then collected by a capacitor 44, which acts a reservoir capacitor. In an embodiment of the invention, the output of the capacitor 44 may be limited by diode 46 to 3.3 volts DC. The voltage from the capacitor 44 is applied to an oscillation circuit 160, which, for example, may be a relaxation oscillator circuit. In this embodiment of the invention, the relaxation oscillation circuit may formed by a first resistor 48, a first transistor 50, a second transistor 52, a second resistor 54, a third resistor 56, and a second capacitor 58. Once the supply voltage from the capacitor 44 has increased to a sufficient level, the oscillation circuit may begin to oscillate. In the embodiment of the invention illustrated in Fig. 1(b), the second capacitor 58 and the second resistor 54 are mostly responsible for determining the time constant of this circuit. Pulses generated from the oscillation circuit are coupled to the base of a third transistor 60 by way of a fourth resistor 62 and a third capacitor 64, which ensure that the pulses of the oscillating waveform are of short duration. The third transistor 60 repeatedly short-circuits the incoming current to increase the current the pulses of the oscillating waveform. The third transistor 60 is ensuring that the oscillating waveform is coupled to the conductor or line that transmits the oscillating waveform back to the main test unit 110. In an embodiment of the invention, narrow pulses need to be utilized because the short-circuiting of the third transistor 60 is interrupting the power flow to the remote unit 130. In an embodiment of the invention, a continuous waveform may also be utilized to transmit information back to the main test unit 10. In this embodiment of the invention, the main test unit 10 can more easily measure the rate of repetition of the oscillating waveform produced by the oscillating circuit. If necessary, the main test unit 10 may reverse the polarity of the power supply 14 to enable the oscillating circuit to produce the necessary rate of repetition.

Once the oscillating waveform signal has been generated, the remote unit 12 transmits the oscillating waveform signal back to the main test unit 10 where the measurement circuit 144 is located. In the embodiment of the invention illustrated in Fig. 1(a), the measurement circuit 144 may include two voltage or potential dividers. A first voltage or potential divider is formed by resistors 66 and 68 and is coupled or connected to an analog to digital converter 74. The second divider is formed by resistors 70 and 72 and is coupled or connected to a comparator 76 with a processor controlled threshold. The comparator 76 increases the resolution of the oscillating waveform signal so that its rate of repetition can be more easily and accurately obtained. The measurement circuit

144 receives the oscillating waveform signal and measures a value of a characteristic of the oscillating waveform signal. Illustratively, the measurement circuit 144 may measure a rate of repetition of the received oscillating waveform signal.

The measured value of the received oscillating waveform signal is compared to values stored in memory 142 of the main unit. In an embodiment of the invention, a comparison circuit or module 145 may compare the measured value of the oscillating waveform signal to the values stored in memory 142. In an embodiment of the invention, the microcontroller 140 may include instructions causing the comparison circuit or module 145 to compare the measured value of the oscillating waveform signal to the values stored in memory 142. The memory 142 includes values for representative characteristics and corresponding cable electrical identification which would produce the characteristics. This comparison determines from which remote unit 12 the signal was sent. In an embodiment of the invention, the comparison circuit or module 145 determines an exact match between the measured value and a table entry. In an embodiment of the invention, the comparison circuit or module 145 determines a closest match between the measured value and a table entry in the memory 142. The cable identification is then known. The cable identification is then communicated to a user. In an embodiment of the invention, the measurement circuitry 144 and memory 142 are included as part of a microcontroller within the main test unit 10. In an embodiment of the invention, the measurement circuitry 144 and the comparison circuitry 145 are included as part of the microcontroller 140 in the main test unit.

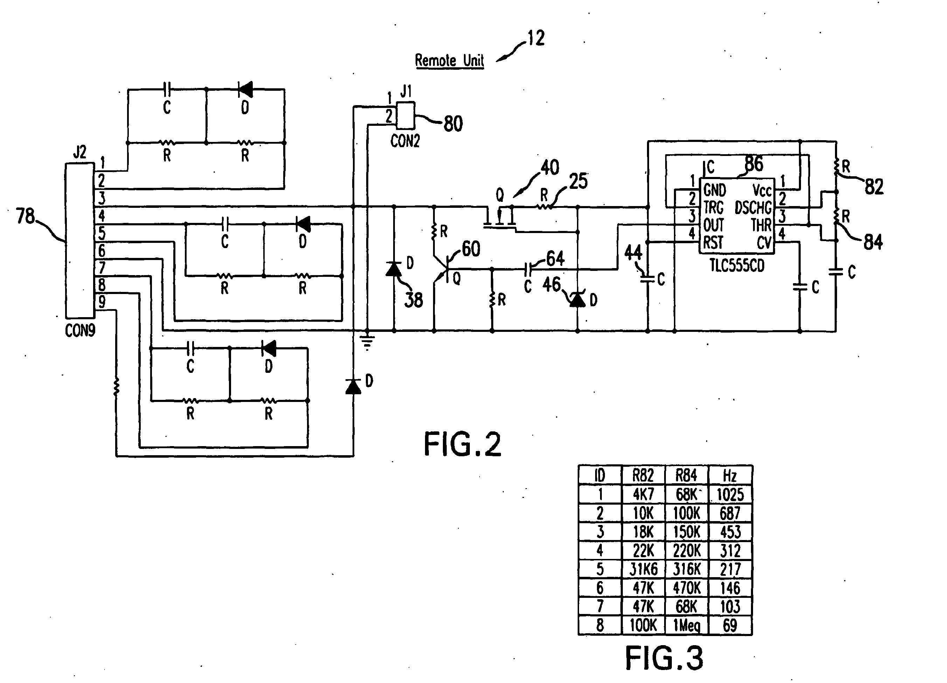

Figure 2 illustrates a schematic of a second remote unit according to an embodiment of the present invention. The remote unit 12 receives power from the main test unit 10. The main test unit 10 for this embodiment is similar to the main unit for the embodiment described above in Fig. 1(a). Illustratively, the remote unit 12 receives power from the main test unit 10 by a nine pin connector 78 for a four twisted pair communications cable and a two pin F connector 80 for a coaxial cable. Both the wiremapping and office ID functions are performed on the pair formed by the third and sixth conductors of a communications cable using the same technique discussed above for Fig. 1(b) of the invention. However, in the embodiment of the invention illustrated in Fig. 2, the remote unit 12 utilizes a different oscillation circuit as compared to Fig. 1(b). In lieu of a relaxation oscillator circuit, this embodiment of the invention utilizes a standard 555 integrated circuit chip 86 in conjunction with resistors 82 and 84 to create the appropriate rate of repetition of the oscillating waveform. In this embodiment of the invention, the value of resistors 82 and 84 may determine this rate of repetition. In all other ways, the circuitry of the remote unit 12 in this embodiment, illustrated in Fig. 2, is similar to the remote unit 12 of the first embodiment, illustrated in Fig. 1(b). An accuracy of the oscillating waveform provided by this embodiment is greater than that provided by the relaxation oscillator circuit of the first embodiment (Fig. 1(b)) and may be preferential for use in many situations. This same technique may be used for the office ID function for any coaxial cable being tested. When performing the wiremapping for the other three pairs of conductors of a communications cable, the prior technique of using a network of capacitors, resistors, and diodes may be employed.

Figure 3 illustrates a table in a memory of a main test unit according to an embodiment of the present invention. The table illustrated in Fig. 3 includes values of resistors 82 and 84 (for the embodiment of the invention illustrated in Fig. 2) that provide eight different oscillating waveforms with eight different rates of repetitions so that eight office ID remotes can be utilized to identify up to eight different cables. A similar table may be stored in memory 142 for the embodiment of the invention illustrated in Fig. 1(b) where the table may include values for the second capacitor 58 and the second resistor 54. In the embodiment of the invention illustrated in Fig. 2, each office ID remote includes the appropriate values of resistors 82 and 84 that produce a rate of repetition that matches the table shown in figure 3 and the office ID and frequency correlation is stored in the memory of the main test unit 10.

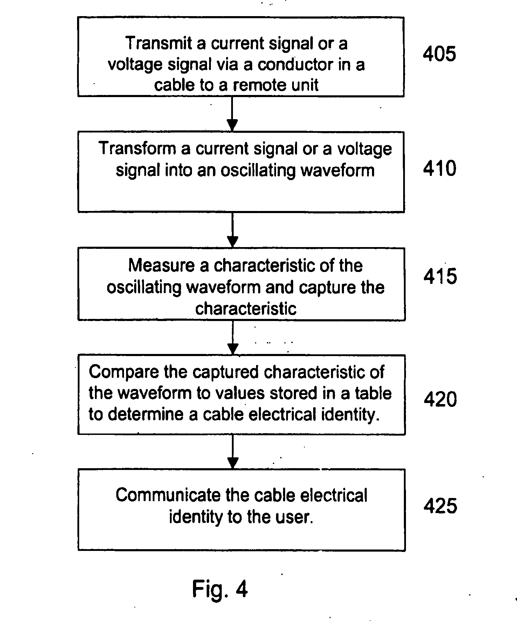

Fig. 4 illustrates a flowchart of performing remote identification of a cable according to an embodiment of the invention. In an embodiment of the invention, a power supply in a main unit transmits 405 a current signal or a voltage signal via a cable to a remote unit. In an embodiment of the invention, the cable has a plurality of conductors and in this embodiment, the main unit transmits the current or voltage signal via one conductor (or a first conductor) of the plurality of conductors in the cable. The remote unit receives the current signal. After receipt of the current signal, an oscillating circuit in the remote unit transforms 410 the current signal into an oscillating waveform or oscillating waveform signal. The remote unit then transfers the oscillating waveform signal to the main unit via the cable. In an embodiment of the invention, a second conductor of the cable is utilized to transfer the oscillating waveform signal to the main test unit. In an embodiment of the invention, the second conductor is different from the first conductor.

The main test unit receives the oscillating waveform signal from the cable. A measurement circuit in the main test unit measures 415 a characteristic of the oscillating waveform and captures the characteristic. In an embodiment of the invention, the characteristic may be a rate of repetition of the waveform.

After measuring a value of the characteristic of the oscillating waveform, the main test unit may compare 420 the captured or measured characteristic of the oscillating waveform to values stored in a table in a memory to determine a cable identity. Each entry in the table in memory may include a representative characteristic and a cable that corresponds to or is associated with the characteristic.

Once the cable characteristic is identified, the cable identity is communicated 425 to a user. The communication may be made by a display on the main test unit. Alternatively, the communication may be made by the main test unit communicating to a computing device or portable computing device. The computing device or the portable device may be separate from the main test unit. In an embodiment of the invention, the communication may take place via wireless communication or wired communication.

As can be seen, the preferred embodiment of the present invention provides a way to accurately perform the office ID function using the rate of repetition of an oscillating waveform created by an integrated circuit chip. However, it is clear that those skilled in the art may devise various modifications.

While the above description refers to particular embodiments of the present invention, it will be understood to those of ordinary skill in the art that modifications may be made.

The presently disclosed embodiments are therefore to be considered in all respects as illustrative and not restrictive; the scope of the invention being indicated by the appended claims, rather than the foregoing description.

## Claims

1. A remote unit (130), comprising:
an input/output (I/O) terminal to receive a current signal from a main test unit (110);
an oscillator circuit (160) to receive the current signal and to transform the current signal into an oscillating waveform having a predetermined characteristic; and
a circuit to receive the oscillating waveform having the predetermined characteristic, the circuit comprising a capacitor (64), a resistor, and a transistor (60), the oscillating waveform being coupled to a base of the transistor (60) by the capacitor (64) and the resistor, wherein the capacitor and the resistor ensure pulses of the oscillating waveform are of short duration and the transistor repeatedly short circuits the incoming current to increase the current of the pulses of the oscillating waveform, and to transfer the oscillating waveform to the I/O terminal for transmission to the main test unit (110).

2. The remote unit (130) of claim 1, further comprising a current protection circuit (164) to limit an amplitude of the current signal to protect the remote unit from being exposed to a high voltage.

3. The remote unit (130) of claim 1, wherein the oscillator circuit (160) is a relaxation oscillator circuit including a network of resistors, capacitors, and transistors.

4. The remote unit (130) of claim 1, wherein the oscillator circuit (160) is a standard integrated circuit chip that generates the oscillating waveform having the predetermined rate of repetition.

5. The remote unit (130) of claim 1, further including a polarity protection circuit (162) to prevent the current signal from damaging the remote unit if the current signal has reversed polarity.

6. A main test unit (110) to apply an electrical identification tag to a cable (120), comprising:
a power supply (146) to generate a current signal and to transmit the current signal to a cable (120) which is connected to a remote unit (130), the remote unit including an oscillator circuit (160), a capacitor (64), a resistor, and a transistor (60) ;
a memory (142), the memory including a table (148), the table having a plurality of values of predetermined characteristics of oscillating waveforms corresponding to cable electrical identification tags;
a measurement circuit (144) to receive an oscillating waveform having a predetermined characteristic from the remote unit (130), the remote unit having transformed the current signal into the oscillating waveform having a predetermined characteristic, the oscillating waveform being coupled to a base of the transistor (60) by the capacitor (64) and the resistor, wherein the capacitor (64) and the resistor ensure pulses of the oscillating waveform are of short duration and the transistor (160) repeatedly short circuits the incoming current to increase the current of the pulses of the oscillating waveform;
and a comparison circuit (145) to compare the predetermined characteristic of the oscillating waveform to the plurality of values of predetermined characteristics stored in the table (148) to determine a match to one of the remote unit identification tags.

7. The main test unit according to claim 6, further including a controller (140) to communicate the matching remote unit identification tag by generating a message.

8. A system to apply an electrical identification tag to a cable, comprising:
a main test unit (110) according to claim 6;
a remote unit (130) according to claim 1; and
a cable (120), the cable including at least two conductors to connect the main test unit (110) and the remote unit (130) in order to transmit the current signal and the oscillating waveform in between, wherein the predetermined characteristic of the oscillating waveform is measured by a measurement circuit (144) and compared to values stored in said memory (142) to determine the electrical identification tag to be associated with said cable (120).

9. The system of claim 8, wherein the power supply (146) of the main test unit (110) is a DC power supply, the cable is a four twisted pair communications cable and at least one pair of the four twisted pair communications cable has an oscillating waveform applied thereto by the remote unit (130).

10. The system of claim 8 wherein the memory (142) and measurement circuit (144) of the main test (110) unit are located in a microcontroller.

11. The system of claim 8, wherein the main test unit (110) also includes a comparison circuit (145) and the comparison circuit compares the measured predetermined characteristic of the oscillating waveform to the values stored in said memory (142) to identify the electrical identification tag of the remote unit (130).

12. The system of claim 11, wherein the memory (142), the measurement circuit (144), and the comparison circuit (145) are located in a microcontroller.

13. The system of claim 8, wherein the remote unit (110) further includes a polarity protection circuit (162), the polarity protection circuit prevents damage to the oscillator circuit (160) if a polarity of the current signal supplied to the remote unit is reversed.

14. The system of claim 13, wherein the polarity protection circuit (164) is a diode and the diode is connected in parallel with the two conductors in the cable.

15. The system of claim 8, wherein the remote unit (110) includes a current protection circuit (164), the current protection circuit limiting a value of current from the current signal to the oscillator circuit (160) to a predetermined level to protect the oscillator circuit from damage if a higher than intended voltage is supplied to the remote unit (110).

16. The system of claim 15, wherein the current protection circuit (164) is a depletion mode MOSFET located between the oscillator circuit (160) and the incoming current signal.

17. The system of claim 8 wherein the oscillator circuit (160) in the remote unit (110) is a relaxation oscillator circuit including a network of resistors, capacitors, and transistors, the relaxation oscillator circuit creating the oscillating waveform having the predetermined characteristic, the predetermined characteristic being a predetermined rate of repetition.

18. The system of claim 8, further including a plurality of remote units, each of the plurality of remote units having a oscillating waveform circuit that is capable of producing an oscillating waveform having a different rate of repetition than the first remote unit and each of the other plurality of remote units.

19. The system of claim 18 wherein the memory (142) of the main test unit (110) includes a table (148) that correlates each of the plurality of remote units with the rate of repetition of the oscillating waveform that the individual remote unit generates.

20. The system of claim 18, wherein each of the plurality of remote units includes an oscillator circuit (160) with an integrated circuit chip that is capable of producing an oscillating waveform having a unique predetermined characteristic.

21. The system of claim 20, wherein the measurement circuit (144) in the main test unit (110) includes a comparator for increasing a resolution of the oscillating waveform so that the unique predetermined characteristic of the oscillating waveform can be more accurately determined.

22. The system of claim 8, wherein the measurement circuit (144) in the main unit (110) includes a comparator for increasing the resolution of the oscillating waveform so that the predetermined characteristic of the oscillating waveform can be more accurately determined.

23. The system of claim 8 wherein the oscillator circuit (160) includes a standard integrated circuit chip that generates an oscillating waveform having a predetermined rate of repetition.

24. The system of claim 8 wherein the remote unit transistor (60) boosts the amplitude of the oscillating waveform so that the oscillating waveform can be more easily measured by the main test unit.

25. A method of identifying a cable (120), the cable including at least two conductors, comprising:
supplying a current signal to a first conductor of the at least two conductors;
transforming said current signal into an oscillating waveform having a predetermined characteristic at a remote unit (130), the remote unit including an oscillator (160), a capacitor (64), a resistor and a transistor (60), the oscillating waveform being coupled to a base of the transistor (60) by the capacitor (64) and the resistor, wherein the capacitor and the resistor ensure pulses of the oscillating waveform are of short duration and the transistor repeatedly short circuits the incoming current to increase the current of the pulses of the oscillating waveform;
measuring a value of said predetermined characteristic of the oscillating waveform at a main test unit (110); and
comparing said value of the characteristic of the oscillating waveform to a table (148) stored in a memory (142) of the main test unit (110) to correlate a cable electrical identity with the value of the characteristic of the oscillating waveform.

26. The method of claim 25, further including communicating the cable electrical identity to a user.

27. The method of claim 25, wherein transforming the current signal includes producing an oscillating waveform with a predetermined rate of repetition and said measuring of said characteristic includes determining a rate of repetition of the oscillating waveform.

28. A program code-storage device, comprising:
a program code storage medium; and
program code stored on the program code storage medium, having instructions, which when executed cause a remote unit to:
receive a current signal from a cable that connects a main test unit to the remote unit;
transform the current signal into an oscillating waveform;
receive the oscillating waveform at a circuit, the circuit comprising a capacitor, a resistor and a transistor, the oscillating waveform being coupled to a base of the transistor by the capacitor and the resistor, wherein the capacitor and the resistor ensure pulses of the oscillating waveform are of short duration and the transistor repeatedly short circuits the incoming current to increase the current of the pulses of the oscillating waveform; and
transmit the oscillating waveform to the main unit.

## Patentansprüche

1. Ferneinheit (130), mit:
einem Eingabe/Ausgabe-Anschluss (E/A-Anschluss), um ein Stromsignal von einer Haupttesteinheit (110) zu empfangen;
einem Schwingkreis (160), um das Stromsignal zu empfangen und das Stromsignal in eine oszillierende Wellenform mit einem vordefinierten Charakteristikum umzuwandeln: und
einem Schaltkreis, um die oszillierende Wellenform mit dem vordefinierten Charakteristikum zu empfangen, wobei der Schaltkreis einen Kondensator (64), einen Widerstand und einen Transistor (60) enthält, wobei die oszillierende Wellenform über den Kondensator (64) und den Widerstand an eine Basis des Transistors (60) gekoppelt ist, wobei der Kondensator und der Widerstand gewährleisten, dass Impulse der oszillierenden Wellenform von kurzer Dauer sind, und wobei der Transistor den eingehenden Strom wiederholt kurzschließt, um den Strom der Impulse der oszillierenden Wellenform zu erhöhen und um die oszillierende Wellenform an den E/A-Anschluss zur Übertragung an die Haupttesteinheit (110) zu transferieren.

2. Ferneinheit (130) nach Anspruch 1, ferner mit einer Stromschutzschaltung (164), um eine Amplitude des Stromsignals zu begrenzen, so dass die Ferneinheit vor einem Aussetzen gegenüber Hochspannung geschützt wird.

3. Ferneinheit (130) nach Anspruch 1, wobei der Schwingkreis (160) ein Kippschwingkreis ist, der ein Netzwerk von Widerständen, Kondensatoren und Transistoren enthält.

4. Ferneinheit (130) nach Anspruch 1, wobei der Schwingkreis (160) ein standardmäßiger integrierter Schaltungschip ist, der die oszillierende Wellenform mit der vordefinierten Repetitionsrate erzeugt.

5. Ferneinheit (130) nach Anspruch 1, ferner mit einer Verpolungsschutzschaltung (162), um zu verhindern, dass das Stromsignal die Ferneinheit beschädigt, wenn das Stromsignal umgepolt ist.

6. Haupttesteinheit (110) zum Versehen eines Kabels (120) mit einer elektrischen Erkennungsmarkierung, wobei die Haupttesteinheit (110) enthält:
eine Stromversorgung (146), um ein Stromsignal zu erzeugen und um das Stromsignal an ein Kabel (120) zu übertragen, das mit einer Ferneinheit (130) verbunden ist, wobei die Ferneinheit einen Schwingkreis (160), einen Kondensator (64), einen Widerstand und einen Transistor (60) aufweist;
einen Speicher (142), wobei der Speicher eine Tabelle (148) enthält, wobei die Tabelle eine Mehrzahl von Werten vordefinierter Charakteristika von oszillierenden Wellenformen aufweist, die den elektrischen Erkennungsmarkierungen des Kabels entsprechen;
eine Messschaltung (144), um eine oszillierende Wellenform mit einem vordefinierten Charakteristikum von der Ferneinheit (130) zu empfangen, wobei die Ferneinheit das Stromsignal in die oszillierende Wellenform mit einem vordefinierten Charakteristikum umgewandelt hat, wobei die oszillierende Wellenform über den Kondensator (64) und den Widerstand an eine Basis des Transistors (60) gekoppelt ist, wobei der Kondensator (64) und der Widerstand gewährleisten, dass Impulse der oszillierenden Wellenform von kurzer Dauer sind, und wobei der Transistor (160) den eingehenden Strom wiederholt kurzschließt, um den Strom der Impulse der oszillierenden Wellenform zu erhöhen;
und eine Vergleichsschaltung (145), um das vordefinierte Charakteristikum der oszillierenden Wellenform mit der Mehrzahl von Werten vordefinierter Charakteristika, die in der Tabelle (148) gespeichert sind, zu vergleichen, um eine Übereinstimmung mit einer der Erkennungsmarkierungen der Ferneinheit zu ermitteln.

7. Haupttesteinheit nach Anspruch 6, ferner mit einem Regler (140), um die übereinstimmende Erkennungsmarkierung der Ferneinheit durch Generieren einer Nachricht zu kommunizieren.

8. System zum Versehen eines Kabels mit einer elektrischen Erkennungsmarkierung, wobei das System enthält:
eine Haupttesteinheit (110) nach Anspruch 6;
eine Ferneinheit (130) nach Anspruch 1; und
ein Kabel (120), wobei das Kabel zumindest zwei Leiter enthält, um die Haupttesteinheit (110) mit der Ferneinheit (130) zu verbinden, so dass das Stromsignal und die oszillierende Wellenform zwischen diesen übertragen wird, wobei das vordefinierte Charakteristikum der oszillierenden Wellenform von einer Messschaltung (144) gemessen und mit im Speicher (142) gespeicherten Werten verglichen wird, um die elektrische Erkennungsmarkierung, die dem Kabel (120) zuzuordnen ist, zu ermitteln.

9. System nach Anspruch 8, wobei die Stromversorgung (146) der Haupttesteinheit (110) eine DC-Stromversorgung ist, wobei das Kabel ein verdrilltes 4-paariges Übertragungskabel ist, und wobei von der Ferneinheit (130) auf zumindest ein Paar des verdrillten 4-paarigen Übertragungskabels eine oszillierende Wellenform angelegt wird.

10. System nach Anspruch 8, wobei der Speicher (142) und die Messschaltung (144) der Haupttesteinheit (110) in einem Mikrocontroller platziert sind.

11. System nach Anspruch 8, wobei die Haupttesteinheit (110) auch eine Vergleichsschaltung (145) enthält, wobei die Vergleichsschaltung das gemessene vordefinierte Charakteristikum der oszillierenden Wellenform mit den im Speicher (142) gespeicherten Werten vergleicht, um die elektrische Erkennungsmarkierung der Ferneinheit (130) zu identifizieren.

12. System nach Anspruch 11, wobei der Speicher (142), die Messschaltung (144) und die Vergleichsschaltung (145) in einem Mikrocontroller vorgesehen sind.

13. System nach Anspruch 8, wobei die Ferneinheit (110) ferner eine Verpolungsschutzschaltung (162) enthält, wobei die Verpolungsschutzschaltung verhindert, dass der Schwingkreis (160) Schaden nimmt, wenn das der Ferneinheit zugeführte Stromsignal umgepolt ist.

14. System nach Anspruch 13, wobei die Verpolungsschutzschaltung (164) eine Diode ist und die Diode mit den beiden Leitern im Kabel parallel geschaltet ist.

15. System nach Anspruch 8, wobei die Ferneinheit (110) eine Stromschutzschaltung (164) enthält, wobei die Stromschutzschaltung einen Wert des Stroms vom Stromsignal an den Schwingkreis (160) auf eine vordefinierte Höhe begrenzt, um den Schwingkreis vor einem Schaden zu schützen, wenn eine Spannung an die Ferneinheit (110) geliefert wird, die höher als gedacht ist.

16. System nach Anspruch 15, wobei die Stromschutzschaltung (164) ein MOSFET-Transistor vom Verarmungstyp ist, der zwischen dem Schwingkreis (160) und dem eingehenden Stromsignal platziert ist.

17. System nach Anspruch 8, wobei der Schwingkreis (160) in der Ferneinheit (110) ein Kippschwingkreis mit einem Netzwerk an Widerständen, Kondensatoren und Transistoren ist, wobei der Kippschwingkreis die oszillierende Wellenform mit dem vordefinierten Charakteristikum erzeugt, wobei das vordefinierte Charakteristikum eine vordefinierte Repetitionsrate ist.

18. System nach Anspruch 8, ferner mit einer Mehrzahl von Ferneinheiten, wobei jede der Mehrzahl von Ferneinheiten einen oszillierende Wellenformen erzeugenden Schaltkreis ("oscillating waveform circuit") hat, der in der Lage ist, eine oszillierende Wellenform mit einer zur ersten Ferneinheit und zu jeder der anderen Mehrzahl von Ferneinheiten unterschiedlichen Repetitionsrate zu erzeugen.

19. System nach Anspruch 18, wobei der Speicher (142) der Haupttesteinheit (110) eine Tabelle (148) enthält, die jede der Mehrzahl von Ferneinheiten mit der Repetitionsrate der oszillierenden Wellenform, die die einzelne Ferneinheit erzeugt, korreliert.

20. System nach Anspruch 18, wobei jede der Mehrzahl von Ferneinheiten einen Schwingkreis (160) mit einem integrierten Schaltungschip enthält, der in der Lage ist, eine oszillierende Wellenform mit einem einzigartigen, vordefinierten Charakteristikum zu erzeugen.

21. System nach Anspruch 20, wobei die Messschaltung (144) in der Haupttesteinheit (110) einen Komparator zum Erhöhen einer Auflösung der oszillierenden Wellenform enthält, so dass das einzigartige, vordefinierte Charakteristikum der oszillierenden Wellenform genauer ermittelt werden kann.

22. System nach Anspruch 8, wobei die Messschaltung (144) in der Haupttesteinheit (110) einen Komparator zum Erhöhen der Auflösung der oszillierenden Wellenform enthält, so dass das vordefinierte Charakteristikum der oszillierenden Wellenform genauer ermittelt werden kann.

23. System nach Anspruch 8. wobei der Schwingkreis (160) einen standardmäßigen integrierten Schaltungschip enthält, der eine oszillierende Wellenform mit einer vordefinierten Repetitionsrate erzeugt.

24. System nach Anspruch 8, wobei der Transistor (60) der Ferneinheit die Amplitude der oszillierenden Wellenform verstärkt, so dass die oszillierende Wellenform von der Haupttesteinheit leichter gemessen werden kann.

25. Verfahren zum Identifizieren eines Kabels (120), wobei das Kabel zumindest zwei Leiter aufweist, wobei das Verfahren umfasst:
Zuführen eines Stromsignals an einen ersten Leiter der zumindest zwei Leiter;
Umwandeln des Stromsignals in eine oszillierende Wellenform mit einem vordefinierten Charakteristikum an einer Ferneinheit (130), wobei die Ferneinheit einen Oszillator (160), einen Kondensator (64), einen Widerstand und einen Transistor (60) enthält, wobei die oszillierende Wellenform über den Kondensator (64) und den Widerstand an eine Basis des Transistors (60) gekoppelt ist, wobei der Kondensator und der Widerstand gewährleisten, dass Impulse der oszillierenden Wellenform von kurzer Dauer sind, und wobei der Transistor den eingehenden Strom wiederholt kurzschließt, um den Strom der Impulse der oszillierenden Wellenform zu erhöhen;
Messen eines Werts des vordefinierten Charakteristikums der oszillierenden Wellenform an einer Haupttesteinheit (110); und
Vergleichen des Werts des Charakteristikums der oszillierenden Wellenform mit einer Tabelle (148), die in einem Speicher (142) der Haupttesteinheit (110) gespeichert ist, um eine elektrische Erkennung des Kabels mit dem Wert des Charakteristikums der oszillierenden Wellenform zu korrelieren.

26. Verfahren nach Anspruch 25, ferner umfassend das Kommunizieren der elektrischen Erkennung des Kabels an einen Benutzer.

27. Verfahren nach Anspruch 25, wobei das Umwandeln des Stromsignals das Erzeugen einer oszillierenden Wellenform mit einer vordefinierten Repetitionsrate umfasst, und wobei das Messen des Charakteristikums das Bestimmen einer Repetitionsrate der oszillierenden Wellenform umfasst.

28. Programmcode-Speichervorrichtung, mit:
einem Programmcode-Speichermedium; und
einem Programmcode, der am Programmcode-Speichermedium gespeichert ist und Instruktionen enthält, die, wenn sie ausgeführt werden, eine Ferneinheit zu den folgenden Schritten veranlassen:
Empfangen eines Stromsignals von einem Kabel, das eine Haupttesteinheit mit der Ferneinheit verbindet;
Umwandeln des Stromsignals in eine oszillierende Wellenform;
Empfangen der oszillierenden Wellenform an einem Schaltkreis, wobei der Schaltkreis einen Kondensator, einen Widerstand und einen Transistor enthält, wobei die oszillierende Wellenform über den Kondensator und den Widerstand an eine Basis des Transistors gekoppelt ist, wobei der Kondensator und der Widerstand gewährleisten, dass Impulse der oszillierenden Wellenform von kurzer Dauer sind, und wobei der Transistor den eingehenden Strom wiederholt kurzschließt, um den Strom der Impulse der oszillierenden Wellenform zu erhöhen; und
Übertragen der oszillierenden Wellenform an die Haupteinheit.

## Revendications

1. Unité distante (130), comprenant :
une borne d'entrée/sortie (E/S) pour recevoir un signal de courant depuis une unité de test principale (110) ;
un circuit oscillateur (160) pour recevoir le signal de courant et pour transformer le signal de courant en une forme d'onde oscillante ayant une caractéristique prédéterminée ; et
un circuit pour recevoir la forme d'onde oscillante ayant la caractéristique prédéterminée, le circuit comprenant un condensateur (64), une résistance, et un transistor (60), la forme d'onde oscillante étant couplée à une base du transistor (60) par le condensateur (64) et la résistance, où le condensateur et la résistance assurent que les impulsions de la forme d'onde oscillante soient de courte durée et le transistor met en court-circuit de manière répétée le courant entrant pour augmenter le courant des impulsions de la forme d'onde oscillante, et pour transférer la forme d'onde oscillante à la borne E/S pour transmission à l'unité de test principale (110).

2. Unité distante (130) de la revendication 1, comprenant en outre un circuit de protection de courant (164) pour limiter l'amplitude du signal de courant pour protéger l'unité distante contre une exposition à une haute tension.

3. Unité distante (130) de la revendication 1, **caractérisée en ce que** le circuit oscillateur (160) est un circuit oscillateur de relaxation comprenant un réseau de résistances, de condensateurs, et de transistors.

4. Unité distante (130) de la revendication 1, **caractérisée en ce que** le circuit oscillateur (160) est une puce à circuit intégré standard qui génère la forme d'onde oscillante ayant la fréquence de répétition prédéterminée.

5. Unité distante (130) de la revendication 1, comprenant en outre un circuit de protection de polarité (162) pour empêcher le signal de courant d'endommager l'unité distante si le signal de courant a une polarité inversée.

6. Unité de test principale (110) pour appliquer une étiquette d'identification électrique à un câble (120), comprenant :
une alimentation électrique (146) pour générer un signal de courant et transmettre le signal de courant à un câble (120) qui est raccordé à une unité distante (130), l'unité distante comprenant un circuit oscillateur (160), un condensateur (64), une résistance, et un transistor (60) ;
une mémoire (142), la mémoire comprenant une table (148), la table ayant une pluralité de valeurs de caractéristiques prédéterminées de formes d'onde oscillantes correspondant à des étiquettes d'identification de câble électrique ;
un circuit de mesure (144) pour recevoir une forme d'onde oscillante ayant une caractéristique prédéterminée depuis l'unité distante (130), l'unité distante ayant transformé le signal de courant en la forme d'onde oscillante ayant une caractéristique prédéterminée, la forme d'onde oscillante étant couplée à une base du transistor (60) par le condensateur (64) et la résistance, où le condensateur (64) et la résistance assurent que les impulsions de la forme d'onde oscillante soient de courte durée et le transistor (160) met en court-circuit de manière répétée le courant entrant pour augmenter le courant des impulsions de la forme d'onde oscillante ;
et un circuit de comparaison (145) pour comparer la caractéristique prédéterminée de la forme d'onde oscillante à la pluralité de valeurs de caractéristiques prédéterminées stockées dans la table (148) pour déterminer une correspondance à l'une des étiquettes d'identification de l'unité distante.

7. Unité de test principale selon la revendication 6, comprenant en outre un dispositif de commande (140) pour communiquer l'étiquette d'identification d'unité distante correspondante en générant un message.

8. Système pour appliquer une étiquette d'identification électrique sur un câble, comprenant :
une unité de test principale (110) selon la revendication 6 ;
une unité distante (130) selon la revendication 1 ; et
un câble (120), le câble comprenant au moins deux conducteurs pour raccorder l'unité de test principale (110) et l'unité distante (130) afin de transmettre le signal de courant et la forme d'onde oscillante entretemps, où la caractéristique prédéterminée de la forme d'onde oscillante est mesurée par un circuit de mesure (144) et comparée aux valeurs stockées dans ladite mémoire (142) pour déterminer l'étiquette d'identification électrique à associer audit câble (120).

9. Système de la revendication 8, **caractérisé en ce que** l'alimentation électrique (146) de l'unité de test principale (110) est une alimentation électrique C.C., le câble est un câble de communication à quatre paires torsadées et au moins une paire du câble de communication à quatre paires torsadées a une forme d'onde oscillante appliquée à celle-ci par l'unité distante (130).

10. Système de la revendication 8 **caractérisé en ce que** la mémoire (142) et le circuit de mesure (144) de l'unité de test principale (110) sont situés dans un microcontrôleur.

11. Système de la revendication 8, **caractérisé en ce que** l'unité de test principale (110) comprend en outre un circuit de comparaison (145) et le circuit de comparaison compare la caractéristique prédéterminée mesurée de la forme d'onde oscillante aux valeurs stockées dans ladite mémoire (142) afin d'identifier l'étiquette d'identification électrique de l'unité distante (130).

12. Système de la revendication 11, **caractérisé en ce que** la mémoire (142), le circuit de mesure (144), et le circuit de comparaison (145) sont situés dans un microcontrôleur.

13. Système de la revendication 8, **caractérisé en ce que** l'unité distante (110) comprend en outre un circuit de protection de polarité (162), le circuit de protection de polarité évite d'endommager le circuit oscillateur (160) si une polarité du signal de courant transmis à l'unité distante est inversée.

14. Système de la revendication 13, **caractérisé en ce que** le circuit de protection de polarité (164) est une diode et la diode est raccordée en parallèle aux deux conducteurs dans le câble.

15. Système de la revendication 8, **caractérisé en ce que** l'unité distante (110) comprend un circuit de protection de courant (164), le circuit de protection de courant limitant une valeur du courant du signal de courant vers le circuit oscillateur (160) à un niveau prédéterminé pour protéger le circuit oscillateur contre les dommages si une tension plus élevée que prévu est appliquée à l'unité distante (110).

16. Système de la revendication 15, **caractérisé en ce que** le circuit de protection de courant (164) est un MOSFET à mode de déplétion situé entre le circuit oscillateur (160) et le signal de courant entrant.

17. Système de la revendication 8 **caractérisé en ce que** le circuit oscillateur (160) dans l'unité distante (110) est un circuit oscillateur de relaxation comprenant un réseau de résistances, condensateurs, et transistors, le circuit oscillateur de relaxation créant la forme d'onde oscillante ayant la caractéristique prédéterminée, la caractéristique prédéterminée étant une fréquence de répétition prédéterminée.

18. Système de la revendication 8, comprenant en outre une pluralité d'unités distantes, chacune de la pluralité d'unités distantes ayant un circuit à forme d'onde oscillante qui est capable de produire une forme d'onde oscillante ayant une fréquence de répétition différente de la première unité distante et de chacune de l'autre pluralité d'unités distantes.

19. Système de la revendication 18 **caractérisé en ce que** la mémoire (142) de l'unité de test principale (110) comprend une table (148) qui corrèle chacune de la pluralité d'unités distantes à la fréquence de répétition de la forme d'onde oscillante que l'unité distante individuelle génère.

20. Système de la revendication 18, **caractérisé en ce que** chacune de la pluralité d'unités distantes comprend un circuit oscillateur (160) avec une puce à circuit intégré qui est capable de produire une forme d'onde oscillante ayant une caractéristique prédéterminée unique.

21. Système de la revendication 20, **caractérisé en ce que** le circuit de mesure (144) dans l'unité de test principale (110) comprend un comparateur pour augmenter une résolution de la forme d'onde oscillante de sorte que la caractéristique prédéterminée unique de la forme d'onde oscillante puisse être plus précisément déterminée.

22. Système de la revendication 8, **caractérisé en ce que** le circuit de mesure (144) dans l'unité principale (110) comprend un comparateur pour augmenter la résolution de la forme d'onde oscillante de sorte que la caractéristique prédéterminée de la forme d'onde oscillante puisse être plus précisément déterminée.

23. Système de la revendication 8 **caractérisé en ce que** le circuit oscillateur (160) comprend une puce à circuit intégré standard qui génère une forme d'onde oscillante ayant la fréquence de répétition prédéterminée.

24. Système de la revendication 8 **caractérisé en ce que** le transistor d'unité distante (60) renforce l'amplitude de la forme d'onde oscillante de sorte que la forme d'onde oscillante peut être plus aisément mesurée par l'unité de test principale.

25. Procédé d'identification d'un câble (120), le câble comprenant au moins deux conducteurs, comprenant :
l'alimentation d'un signal de courant à un premier conducteur des au moins deux conducteurs :
la transformation dudit signal de courant en une forme d'onde oscillante ayant une caractéristique prédéterminée à une unité distante (130), l'unité distante comprenant un oscillateur (160), un condensateur (64), une résistance et un transistor (60), la forme d'onde oscillante étant couplée à une base du transistor (60) par le condensateur (64) et la résistance, où le condensateur et la résistance assurent que les impulsions de la forme d'onde oscillante soient de courte durée et le transistor met en court-circuit de manière répétée le courant entrant de manière à augmenter le courant des impulsions de la forme d'onde oscillante ;
la mesure d'une valeur de ladite caractéristique prédéterminée de la forme d'onde oscillante au niveau d'une unité de test principale (110) ; et
la comparaison de ladite valeur de la caractéristique de la forme d'onde oscillante à une table (148) stockée dans une mémoire (142) de l'unité de test principale (110) pour corréler une identité électrique du câble à la valeur de la caractéristique de la forme d'onde oscillante.

26. Procédé de la revendication 25, comprenant en outre la communication de l'identité électrique du câble à un utilisateur.

27. Procédé de la revendication 25, **caractérisé en ce que** la transformation du signal de courant comprend la production d'une forme d'onde oscillante avec une fréquence de répétition prédéterminée et ladite mesure de ladite caractéristique comprend la détermination d'une fréquence de répétition de la forme d'onde oscillante.

28. Dispositif de stockage de code de programme, comprenant :
un support de stockage de code de programme ; et
un code de programme stocké sur le support de stockage de code de programme, comprenant des instructions qui, lorsqu'elles sont exécutées, amènent une unité distante à :
recevoir un signal de courant depuis un câble qui raccorde une unité de test principale à l'unité distante ;
transformer le signal de courant en une forme d'onde oscillante ;
recevoir la forme d'onde oscillante au niveau d'un circuit, le circuit comprenant un condensateur, une résistance et un transistor, la forme d'onde oscillante étant couplée à une base du transistor par le condensateur et la résistance, où le condensateur et la résistance assurent que les impulsions de la forme d'onde oscillante sont de courte durée et le transistor met en court-circuit de manière répétée le courant entrant pour augmenter le courant des impulsions de la forme d'onde oscillante ; et
transmettre la forme d'onde oscillante à l'unité principale.
